# EUROPEAN PATENT APPLICATION

(11) **EP 2 977 415 A1**
(43) Date of publication of application: **27.01.2016**
(21) Application number: 15189199.1
(22) Date of filing: 09.10.2015
(51) Int. Cl.: C09D 11/00, C09D 11/30, C09D 11/52, H01B 1/14, H01B 1/20, H01L 23/552, H05K 1/02, H05K 1/09

(54) **INKJET FORMULATIONS CONTAINING PEDOT/PSS AND METAL NANOWIRES**

(71) Applicant: Heraeus Deutschland GmbH & Co. KG, 63450 Hanau (DE)
(72) Inventor: The designation of the inventor has not yet been filed
(74) Representative: Herzog, Fiesser & Partner Patentanwälte PartG mbB

(57) **Abstract**

The present invention relates to a composition comprising
(i) at least one conductive polymer;
(ii) metal nanowires;
(iii) a first solvent having a boiling point in the range from 80 to 120°C;
(iv) a second solvent having a boiling point of more than 150°C; and
(v) at least one surfactant.

The invention also relates to process for the production of a layered body comprising an electrically conductive layer deposited onto a substrate, to a layered body obtainable by this process and to the use of the composition according to the present invention.

## Description

The present invention relates to a composition comprising at least one conductive polymer, metal nanowires, a first and a second solvent and at least one surfactant. The invention also relates to process for the production of a layered body comprising an electrically conductive layer deposited onto a substrate, to a layered body obtainable by this process and to the use of the composition according to the present invention.

With recent development of electronic industry, there is a demand for miniaturization and high reliability of electronic products and devices. To meet the demand, various attempts have been made to form circuit patterns or electrodes of electronic products requiring high integration. Under such circumstances, use of a conductive metal paste is the center of interest because it hardly generates by-products or contaminants during a process.

A typical metal paste includes a conductive metal such as particulate silver, a glass frit and an organic binder. Such a conductive metal paste is mainly used to mount a hybrid IC or a semiconductor IC, or to form various condensers or electrodes, and recently has the expanded application range to high-tech electronic products such as PCBs, ELs, RFIDs, LCDs, PDPs, solar cells or touch screen panels.

Touch screen panels generally comprise an insulative (e.g. glass) substrate and a resistive layer disposed on the insulative substrate. A pattern of conductive electrodes are then formed on the edges of the resistive layer. Normally, the edge electrode pattern is printed directly on the resistive layer of the touch screen panel by means of screen printing. In the screen printing method, a printing mask formed with a predetermined pattern thereon is used. The printing mask is placed at a predetermined distance from an object to be printed placed on a printing stage, and the metal paste is applied on the printing mask.

One disadvantage of the screen printing technique is that the silver paste must be characterized by high silver loadings to enable the formation of electrodes with a sufficiently conductivity. These high silver loadings and also the low yield are making this approach of applying a conductive pattern onto a substrate quite expensive. A further disadvantage of the screen printing technique is the use of a stencil which has to be exactly positioned onto the substrate to be coated. Another disadvantage is that silver pastes are optically non-transparent owing to the high silver particle content.

The object of the present invention was to overcome the disadvantages arising from the prior art in connection with the application of conductive patterns based on silver-containing materials.

In particular it was an object of the present application to provide a silver-containing composition that can be used for the formation of a conductive pattern onto a substrate, wherein the composition allows the production of the conductive pattern with reduced costs compared to the process known from the prior art in which silver pastes are applied by means of the screen printing technique.

Furthermore, it was an object of the present invention to provide a process for the production of an electrically conductive layer, in particular for the formation of an electrically conductive layer having a patterned structure, the process being characterized in that it allows the formation of a conductive, transparent layer with reduced costs and reduced complexity, especially with less process steps and less devices such as printing stencils or printing masks, compared to the screen printing technique known from the prior art.

A contribution towards solving these objects is made by a composition comprising
(i) at least one conductive polymer;
(ii) metal nanowires;
(iii) a first solvent having a boiling point in the range from 80 to 120°C;
(iv) a second solvent having a boiling point of more than 150°C;
   and
(v) at least one surfactant.

Surprisingly, it has been discovered that by means of the compositions according to the present invention, which can be applied onto the surface of a substrate by means of an inkjet-process, conductive patterns can be produced in a very simple and cost effective manner.

### Conductive polymers

The composition according to the present invention comprises, as component i), at least one conductive polymer, wherein the conductive polymer is preferably selected from the group consisting of an optionally substituted polythiophene, an optionally substituted polypyrrole, an optionally substituted polyaniline or a mixture of at least two of these polymers.

In this context, optionally substituted polythiophenes are particularly preferred as the conductive polymer, in particular polythiophenes having the general formula 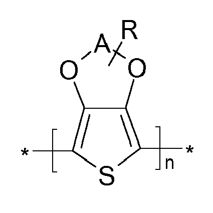 in which
- A: represents an optionally substituted C₁-C₅-alkylene radical,
- R: represents a linear or branched, optionally substituted C₁-C₁₈-atkyl radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxyl radical, wherein 0 to 8 radicals R can be bonded to A and, in the case of more than one radical, can be identical or different.

The polythiophenes preferably in each case carry H on the end groups.

In the context of the invention, C₁-C₅-alkylene radicals A are preferably methylene, ethylene, n-propylene, n-butylene or n-pentylene. C₁-C₁₈-alkyl R preferably represent linear or branched C₁-C₁₈-alkyl radicals, such as methyl, ethyl, n- or iso-propyl, n-, iso-, sec- or tert-butyl, n-pentyl, 1-methylbutyl, 2-methylbutyl, 3-methylbutyl, 1-ethylpropyl, 1,1-dimethylpropyl, 1,2-dimethylpropyl, 2,2-dimethylpropyl, n-hexyl, n-heptyl, n-octyl, 2-ethylhexyl, n-nonyl, n-decyl, n-undecyl, n-dodecyl, n-tridecyl, n-tetradecyl, n-hexadecyl or n-octadecyl, C₅-C₁₂-cycloalkyl radicals R represent, for example, cyclopentyl, cyclohexyl, cycloheptyl, cyclooctyl, cyclononyl or cyclodecyl, C₅-C₁₄-aryl radicals R represent, for example, phenyl or naphthyl, and C₇-C₁₈-aralkyl radicals R represent, for example, benzyl, o-, m-, p-tolyl, 2,3-, 2,4-, 2,5-, 2,6-, 3,4-, 3,5-xylyl or mesityl. The preceding list serves to illustrate the invention by way of example and is not to be considered conclusive.

In the context of the invention, numerous organic groups are possible as optionally further substituents of the radicals A and/or of the radicals R, for example alkyl, cycloalkyl, aryl, aralkyl, alkoxy, halogen, ether, thioether, disulphide, sulphoxide, sulphone, sulphonate, amino, aldehyde, keto, carboxylic acid ester, carboxylic acid, carbonate, carboxylate, cyano, alkylsilane and alkoxysilane groups and carboxamide groups.

Polythiophenes in which A represents an optionally substituted C₂-C₃-alkylene radical are particularly preferred. Poly(3,4-ethylenedioxythiophene) is very particularly preferred as the polythiophene.

The polythiophenes can be neutral or cationic. In preferred embodiments they are cationic, "cationic" relating only to the charges on the polythiophene main chain. The polythiophenes can carry positive and negative charges in the structural unit, depending on the substituent on the radicals R, the positive charges being on the polythiophene main chain and the negative charges optionally being on the radicals R substituted by sulphonate or carboxylate groups. In this context, the positive charges of the polythiophene main chain can be partly or completely satisfied by the anionic groups optionally present on the radicals R. Overall, in these cases the polythiophenes can be cationic, neutral or even anionic. Nevertheless, in the context of the invention they are all regarded as cationic polythiophenes, since the positive charges on the polythiophene main chain are the deciding factor. The positive charges are not shown in the formulae, since their precise number and position cannot be determined absolutely. However, the number of positive charges is at least 1 and at most n, where n is the total number of all recurring units (identical or different) within the polythiophene.

For compensation of the positive charge of the polythiophene, the conductive polymer furthermore comprises a polyanion which is preferably based on polymers functionalized with acid groups. Anions of polymeric carboxylic acids, such as polyacrylic acids, polymethacrylic acid or polymaleic acids, or of polymeric sulphonic acids, such as polystyrenesulphonic acids and polyvinylsulphonic acids, are possible in particular as the polyanion. These polycarboxylic and -sulphonic acids can also be copolymers of vinylcarboxylic and vinylsulphonic acids with other polymerizable monomers, such as acrylic acid esters and styrene. Polyanions which are furthermore possible are perfluorinated, colloid-forming polyanions, which are commercially obtainable, for example, under the name Nafion^{®}. The molecular weight of the polymers which are functionalized with acid groups and supply the polyanions is preferably 1,000 to 2,000,000, particularly preferably 2,000 to 500,000. The polymers functionalized with acid groups or their alkali metal salts are commercially obtainable, e.g. polystyrenesulphonic acids and polyacrylic acids, or can be prepared by known processes (see e.g. Houben Weyl, Methoden der organischen Chemie, vol. E 20 Makromolekulare Stoffe, part 2, (1987), p. 1141 et seq.).

Polymers functionalized with acid groups (polyanions) and polythiophenes, in particular polystyrenesulphonic acid and poly(3,4-ethylenedioxythiophene), can be present in the conductive polymer i) in a weight ratio of from 0.5 : 1 to 50 : 1, preferably from 1 : 1 to 30 : 1, particularly preferably 1 : 1 to 20 : 1. The weight of the electrically conductive polymers here corresponds to the weight of the monomers employed for the preparation of the conductive polymers, assuming that complete conversion takes place during the polymerization.

Preferably, the conductive polymer i) comprise complexes of a polythiophene and a polyanion, particularly preferably PEDOT/PSS complexes, the complexes of the polythiophene and the polyanion preferably being present in the form of particles, in particular in the form of swollen gel particles. Such complexes are obtainable by polymerizing the thiophene monomers, preferably 3,4-ethylenedioxythiophene, oxidatively in aqueous solution in the presence of the polyanions, preferably the polystyrenesulphonic acid. In this context it is particularly preferred that particles comprising the polythiophene/polyanion-complex have been obtained by polymerizing thiophene monomers, in particular 3,4-ethylenedioxythiophene, in the presence of the polyanions, in particular polystyrene sulfonic acid, under a pressure below atmospheric pressure (i. e. 1013.25 hPa at sea level), preferably under a pressure of below 800 hPa, more preferably under a pressure of below 200 hPa and most preferably under a pressure of below 50 hPa.

The particles comprising the polythiophene/polyanion-complex preferably have a weight average particle diameter of less than 100 nm, preferably less than 90 nm, more preferably less than 80 nm, even more preferably less than 70 nm, even more preferably less than 60 nm and most preferably less than 50 nm. It is also preferred that the particles comprising the polythiophene/polyanion-complex have a d₁₀ value of greater than 1 nm and a d₉₀ value of less than 400 nm, particularly preferably a d₁₀ value of greater than 5 nm and a d₉₀ value of less than 200 nm, very particularly preferably a d₁₀ value of greater than 10 nm and a d₉₀ value of less than 60 nm. In this context, the d₁₀ value of the diameter distribution states that 10% of the total weight of all the particles comprising the polythiophene/polyanion-complex can be assigned to those particles which have a diameter of less than or equal to the d₁₀ value. The d₉₀ value of the diameter distribution states that 90% of the total weight of all the particles comprising the polythiophene/polyanion-complex can be assigned to those particles which have a diameter of less than or equal to the d₉₀ value.

### Metal nanowires

The composition according to the present invention comprises, as component ii), metal nanowires, preferably nanowires based on a metal selected from the group consisiting of silver, copper, gold and platinum, wherein the use of silver nanowires is particularly preferred. Preferably, the metal nanowires ii), in particular the silver nanowires, contained in the composition according to the present invention are characterized by a length of from 1 µm to 200 µm and by a diameter of from 50 nm to 1,300 nm. Preferably, the metal nanowires have an aspect ratio (length : diameter) of at least 10 : 1, more preferably of at least 100 : 1 and most preferably they have an aspect ratio in a range of from 100 : 1 to 1,000 : 1.

Suitable silver nanowires that can be used as component ii) in the composition according to the present invention can be obtained by a process comprising the process steps:
a) the reduction of silver salts by means of a polyol serving as a solvent and reducing agent in the presence of a non-conductive polymer and subsequent precipitation of the silver nanowires formed thereby to obtain silver nanowires, on the surface of which at least some of the non-conductive polymer is adsorbed;
b) the at least partial removal of the non-conductive polymer adsorbed on the surface of the silver nanowires to obtain purified silver nanowires;

In process step a) silver salts are first reduced by means of a polyol serving as a solvent and reducing agent in the presence of a non-conductive polymer, and the silver nanowires formed by this procedure are then precipitated. This fundamental principle of the production of silver nanowires is adequately known from the prior art, for example from DE-A-10 2010 017706. Furthermore silver nanowires are available commercially for example form Cambrios, CA, USA.

### First solvent

The composition according to the present invention comprises as component iii) a first solvent having a boiling point in the range from 80 to 120°C, preferably in the range from 90 to 110°C (the boiling point being determined at 1013 mbar), wherein the first solvent is preferably water, isopropanol, propanol, 1-butanol and mixtures thereof.

### Second solvent

The composition according to the present invention comprises as component iv) a second solvent having a boiling point of more than 150°C, preferably of more than 175°C (the boiling point being determined at 1013 mbar). Preferably, the second solvent is a solvent that comprises less than two hydroxy groups, wherein solvents selected from the group consisting of dimethylsulphoxide (DMSO), ethylenglycole, methylacetamide, dimethylacetamide, dimethylformamide, N-methylpyrrolidone, N-cyclohexylpyrrolidone, terpeniol or a mixture of at least two of these solvents are particularly preferred and wherein DMSO is most preferred.

The content of the second solvent having a boiling point of more than 150°C in the composition according to the present invention is preferably more than 10 wt.-%, more preferably more than 12,5 wt.-% and even more preferably more than 15 wt.-%, wherein the content is particularly preferred in the range from 12.5 to 50 wt.-%, more preferred in the range from 13.5 to 45 wt.-% and most preferred from 15 to 40 wt.-%, in each case based on the total weight of the composition according to the present invention.

### Surfactant

The composition according to the present invention comprises as component v) at least one surfactant. "Surfactant" is understood as meaning amphiphilic substances which have a hydrophilic head group and a hydrophobic part. The hydrophilic group can be either ionic or nonionic in nature. Due the molecular structure and the tendency to accumulate at interfaces, this substance class lowers the interfacial tension and leads to improved wetting properties. Suitable surfactants are, in particular, anionic surfactants, such as e.g. alkylbenzenesulphonic acids and salts, paraffinsulphonates, alcohol sulphonates, ether sulphonates, sulphosuccinates, phosphate esters, alkyl ether carboxylic acids or carboxylates, cationic surfactants, such as e.g. quaternary alkylammonium salts, nonionic surfactants, in particular non-ionic amphiphilic surfactants, such as e.g. linear or branched alcohol ethoxylates, oxo alcohol ethoxylates, alkylphenol ethoxylates or alkyl polyglucosides. Representative examples of suitable surfactants include fluorosurfactants such as ZONYL^{®} surfactants, including ZONYL^{®} FSN, ZONYL^{®} FSO, ZONYL^{®} FSA, ZONYL^{®} FSH (DuPont Chemicals, Wilmington, Del.), and NOVEC^{®} (3M, St. Paul, Minn.). Other exemplary surfactants include non-ionic surfactants based on alkylphenol ethoxylates. Preferred surfactants include, for example, octylphenol ethoxylates such as TRITON^{®} (x100, x114, x45), and secondary alcohol ethoxylates such as TERGITOL^{®} 15-S series (Dow Chemical Company, Midland Mich.). Further exemplary non-ionic surfactants include acetylenic-based surfactants such as DYNOL^{®} (604, 607) (Air Products and Chemicals, Inc., Allentown, Pa.), n-dodecyl [beta]-D-maltoside and alcohol ethoxylates such as TERGITOL^{®} TMN, in particular TERGITOL^{®} TMN-3, TERGITOL^{®} TMN-6 or TERGITOL^{®} TMN-10.

### Further additives

The composition according to the present invention may comprise as component vi) at least one further additive that is different from the above described components i) to v). Suitable additives comprise antioxidants, adhesion promoters, crosslinkers, binders and bases for regulation of the pH.

Antioxidants are reagents which prevent the oxidative degradation of materials, which is often promoted by UV light. In the case of a use of polythiophenes as the conductive polymer, aromatic polyhydroxy compounds have proved suitable. Antioxidants which are particularly preferred according to the invention are gallic acid and the propyl esters of gallic acid, since they have an inhibiting effect in the conductive layers produced from the composition according to the present invention. The amount in which the gallic acid or the propyl esters of gallic acid are employed in the process according to the invention is preferably in a range of from 0.001 to 5 wt.-%, particularly preferably in a range of from 0.005 to 1 wt.-% and most preferably in a range of from 0.01 to 0.2 wt.-%, in each case based on the total weight of the composition according to the present invention.

Possible adhesion promoters are, in particular, organofunctional silanes and hydrolysates thereof, e.g. 3-glycidoxypropyltrialkoxysilane, 3-aminopropyltriethoxysilane, 3-mercapto-propyltrimethoxysilane, 3-methacryloxypropyltrimethoxysilane, vinyltrimethoxysilane or octyltriethoxysilane, while crosslinking agents which can be employed are melamine compounds, masked isocyanates, functional silanes - e.g. tetraethoxysilane, alkoxysilane hydrolysates, e.g. based on tetraethoxysilane, epoxysilanes, such as 3-glycidoxypropyltrialkoxysilane, epoxides or oxetanes.

Suitable binders are water-soluble binders such as polyvinyl alcohol and derivatives thereof, starch, SBR latex, gelatin, alginates, carboxycellulose and hydroxyalkyl cellulose materials, polyacrylic acid and derivatives thereof, polyvinyl pyrrolidone, casein, polyethylene glycol, polyurethanes (for example, a modified polyurethane resin dispersion), polyamide resins (for instance, an epichlorohydrin-containing polyamide) or mixtures of at least two of these polymers.

Preferred bases for regulation of the pH are, in addition to ammonia, alkali metal hydroxides and alkaline earth metal hydroxides, in particular amines, particularly preferably primary, secondary or tertiary amines in which the alkyl groups are chosen from the group consisting of methyl-, ethyl-, n-propyl- or iso-propyl-. An example of a suitable amine is dimethylaminoethanol.

According to a preferred embodiment of the composition according to the present invention composition comprises:
(i) 0.05 to 5 wt.-%, preferably 0.1 to 2.5 wt.-% and more preferably 0.25 to 1.0 wt.-% of the at least one conductive polymer, wherein in case of a polythiophene/polyanion-complex these values refer to the total weight of polythiophene and polyanion;
(ii) 0.05 to 5 wt.-%, preferably 0.1 to 2.5 wt.-% and more preferably 0.12 to 1.0 wt.-% metal nanowires, preferably silver nanowires;
(iii) 40 to 90 wt.-%, preferably 50 to 85 wt.-% and more preferably 60 to 80 wt.-% of the first solvent having a boiling point in the range from 80 to 120°C, preferably water;
(iv) 12.5 to 50 wt.-%, preferably 15 to 45 wt.-% and more preferably 17.5 to 40 wt.-% of the second solvent having a boiling point of more than 150°C, preferably DMSO;
(v) 0.05 to 5 wt.-%, preferably 0.1 to 2.5 wt.-% and more preferably 0.15 to 1.0 wt.-% of the at least one surfactant, and
(vi) optionally up to 5 wt.-%, preferably up to 0.01 to 2.5 wt.-% and more preferably 0.1 to 1.0 wt.-% of at least one further additive being different from components (i) to (v),
wherein the sum of the amount of components (i) to (vi) is 100 wt.-%.

The viscosity of the composition according to the present invention is preferably in the range from 5 to 80 mPa·s, more preferably in the range of from 10 to 60 mPa·s and most preferably in the range of from 15 to 45 mPa·s.

The composition according to the present invention can be prepared by mixing the metal nanowires ii), preferably the purified silver nanowires obtained in process step b), with an aqueous dispersion comprising the conductive polymer i), preferably with an aqueous dispersion comprising particles comprising complexes of a polythiophene and a polyanion, particularly preferably PEDOT/PSS complexes and water as solvent the solvent iii), with solvent iv), surfactant v) and optionally the further additives vi). The solids content of such dispersions is conventionally in a range of from 0.1 to 10 wt.-%, particularly preferably in a range of from 0.7 to 5 wt.-%.

A contribution towards achieving the abovementioned objects is also made by a process for the production of a layered body, comprising the process steps:
I) the provision of a substrate;
II) the application of a composition according to the present invention onto this substrate by means of inkjet printing;
III) the at least partial removal of the first solvent iii) and the second solvent iv) from the composition to obtain a layered body comprising an electrically conductive layer coated onto the substrate.

In process step I) a substrate is first provided, wherein the nature of the substrate depends on the intended purpose for which the composition according to the present invention is employed. If the dispersion is employed, for example, for the production of transparent electrodes or for addressing transparent electrodes (bus-bars) the substrate needs to be transparent. Possible transparent substrates are in particular, films, particularly preferably polymer films, very particularly preferably polymer films of thermoplastic polymers, polyimides or glass plates.

In process step II) a composition according to the present invention is then applied onto the substrate by means of inkjet printing. In this context it may be advantageous to purify the composition by means of filtration, preferably by means of filtration through a filter having openings of 200 µm or less, preferably 100 µm or less and more preferably 50 µm or less before it is applied by inkjet printing. For applying the optionally filtered composition onto the substrate by inkjet printing the composition according to the present invention is filled into a cartridge of an inkjet printer and is subsequently applied through the nozzles of the printer onto the substrate, preferably in the form of a pattern comprising a plurality of thin lines or isolated objects formed from the composition according to the present invention.

In process step III), at least a part of the first solvent iii) and the second solvent iv) is then removed from the composition to obtain a layered body comprising an electrically conductive layer coated onto the substrate, this removal preferably being carried out by a drying at a temperature in a range of from 20 °C to 200 °C of the substrate coated with the composition. In this context it is particularly preferred that the deposited electrically conductive layer obtained after the at least partial removal of the solvents is deposited in xy-areas which are more than 10 times, preferably more than 50 times and more preferably more than 100 times longer in x direction than in y direction.

A contribution towards achieving the abovementioned objects is also made by a layered body obtainable which is obtainable by the process described above.

The surface resistance of the deposited conductive layer coated onto the substrate is preferably less than 200 Ω/□, more preferably less than 150 Ω/□ and most preferably less than 50 Ω/□. The transmission of the layered body in those areas in which the substrate is coated with the conductive layer is preferably at least 80 %, more preferably at least 85 % and most preferably at least 90 %.

A contribution towards achieving the abovementioned objects is also made by the use of the composition according to the present invention for the production of an electrically conductive layer in an OLED, an OPV element, a touch screen, for shielding from electromagnetic radiation ("EMI shielding"), in sensors, for the production of an IR reflection layer, in transparent heaters and in smart windows, wherein the electrically conductive layer is prepared by means of inkjet printing.

In this context it is particularly preferred to use the composition according to the present invention for the deposition of bezel electrodes in touch panel devices, in particular for the deposition of bezel electrodes in touch panel devices by means of inkjet printing.

The invention is now explained in more detail with the aid of test methods and non-limiting examples.

### TEST METHODS

### Determination of the surface resistance

The surface resistance (SR) of the coatings is determined by means of the 4-point measurement method (4-point sensor Mitsubishi ESP equipped with a Loresta-AX MCP-T370 tester) and stated in Ω/□.

### Determination of the transmission (T)

The transmission of the coated substrates is determined on a 2-channel spectrometer (Lambda900, PerkinElmer). In order to rule out interferences of the scattered light here, the sample is measured in a photometer sphere (Ulbricht sphere), as a result of which scattered light and transmitted light are detected by the photodetector. The transmission is thus understood as meaning the absorption of the coating and of the substrate.

The transmission of the pure substrate is first measured. Melinex 506 films having a thickness of 175 µm are used as the substrate. Thereafter, the coated substrate is measured.

The transmission spectra are recorded in the range of visible light, i.e. from 320 nm to 780 nm with a step width of 5 nm.

The standard colour value Y of the sample is calculated from the spectra in accordance with DIN 5033, taking as the basis a 10° observer angle and light type D65. The internal transmission is calculated from the ratio of the standard colour values of the substrate with coating (Y) to that without coating (Y₀). The internal transmission corresponds to Y/Y₀ × 100 in per cent. For simplicity, only transmission is referred to the in the following.

### Determination of the haze (H)

Haze values were measured on a Haze-gard plus instrument from BYK Gardner (Geretsried).

### Viscosity

The viscosity is measured using a Rheometer (Haake RV1). The rheometer is equipped with a thermostat, a DG 43 beaker (Haake) and a DG 43 rotary (Haake). 12 ml of the dispersion are filled into the beaker. The temperature is fixed at 20°C using the thermostat. In order to equilibrate the temperature the liquid is kept at a sheer-rate of 50 s⁻¹ for 240 seconds. Subsequently the sheer-rate is increase to 100 s⁻¹ (see each measurement). The liquid is then kept for 30 seconds at this sheer-rate. Over the next 30 seconds 30 viscosity measurements are made at the above mentioned sheer-rate (1 measurement/second). The average of those 30 measurements is the final viscosity value.

### Example 1

An inkjet composition is prepared by mixing 6.69 g Silver Nanowire dispersion in water (, 0.97% solid content, 64,8 mg) with 4.81 g water, 15.7 g Clevios PEDOT:PSS (Heraeus, 1.0% solid content, 161.7 mg PEDOT : PSS with a PEDOT : PSS ratio of 1 : 2.5), 6.8 g DMSO (20 wt% of total composition) and 100 µL nonionic surfactant.

The composition was filtered through a 50 µm mesh.

### Example 2: coating of the composition of Example 1 by means of a wire bar

This composition was coated by wire bars (Erichsen) on Melinex 506 (PET, 175 µm, primered on both sides, DuPont). Coatings were dried in a confection oven for 5 minutes at 120 °C.

| Wet-film thickness [µm] | SR [Ω/□] | Y [%] | H [%] |
|---|---|---|---|
| 4 | 199 | 90,2 | 0,9 |
| 6 | 112 | 90,1 | 1,0 |
| 12 | 49 | 88,0 | 1,6 |

### Example 3

### Coating of the composition of Example 1 by means of inkjet printing:

Inkjet printing was conducted with a Dimatix DMP 2831 inkjet printer. Standard Inkjet cartridges were filled with the composition of example 1 one day before printing, to prevent bubbles and cavities in the cartridge and printing head. Printing of several features was conducted on PET (Melinex) as well as on glass (precleaned in a dish washer and ozonized directly before printing). Squares of 1 × 1 mm², 10 × 10 mm², 25 × 25 mm² and 50 × 50 mm² were printed as uniform areas at parameter settings of 45 µm drop separation and 10.2° printhead angle.

### Example 4

### Coating of the composition of Example 1 by means of inkjet printing:

The same cartridge as in example 3 was used for further printing experiments after storing the cartridge filled with the formulation of example 1 for 3 days under ambient conditions.

| Wet-film thickness [µm] | Substrate | SR [Ω/□] |
|---|---|---|
| Example 3 | Glass | 134 |
| Example 4 | Glass | 140 |
| Example 3 | Melinex | 144 |
| Example 4 | Melinex | 145 |

Surface resistance correlates well for the inkjetted features to the expectation out of the wire bare coating results. A coating thickness of 45-50 nm was found for the printed features, correlating to a wet film thickness of approximately 5 µm. The printed areas were uniform and transparent.

## Claims

1. A composition comprising
(i) at least one conductive polymer;
(ii) metal nanowires;
(iii) a first solvent having a boiling point in the range from 80 to 120°C;
(iv) a second solvent having a boiling point of more than 150°C; and
(v) at least one surfactant.

2. The composition according to claim 1, wherein the at least one conductive polymer (i) is an optionally substituted polythiophene.

3. The composition according to claim 2, wherein the polythiophene is a cationic polythiophene that is present in the form of particles comprising a polythiophene/polyanion-complex.

4. The composition according to claim 3, wherein the polythiophene/polyanion-complex is PEDOT/PSS.

5. The composition according to one of the preceding claims, wherein the metal nanowires (ii) are silver nanowires.

6. The composition according to one of the preceding claims, wherein the first solvent (iii) is water.

7. The composition according to one of the preceding claims, wherein the second solvent (iv) is selected from the group consisting of dimethylsulphoxide (DMSO), methylacetamide, dimethylacetamide, dimethylformamide, N-methylpyrrolidone, N-cyclo-hexylpyrrolidone, terpeniol or a mixture of at least two of these solvents.

8. The composition according to one of the preceding claims, wherein the at least one surfactant (v) is a nonionic amphiphilic polymer.

9. The composition according to one of the preceding claims, wherein the composition comprises:
(i) 0.05 to 5 wt.-% of the at least one conductive polymer;
(ii) 0.05 to 5 wt.-% metal nanowires;
(iii) 40 to 90 wt.-% of the first solvent having a boiling point in the range from 80 to 120°C;
(iv) 12.5 to 50 wt.-% of the second solvent having a boiling point of more than 150°C; and
(v) 0.05 to 5 wt.-% of the at least one surfactant, and
(vi) optionally up to 5 wt.-% of at least one further additive being different from components (i) to (v),
wherein the sum of the amount of components (i) to (vi) is 100 wt.-%.

10. A process for the production of a layered body, comprising the process steps:
I) the provision of a substrate;
II) the application of a composition according to one of claims 1 to 9 to the substrate by means of inkjet printing;
III) the at least partial removal of the first solvent (iii) and the second solvent (iv) from the composition to obtain an electrically conductive layer deposited on the substrate.

11. A layered body, obtainable by the process according to claim 10.

12. The layered body according to claim 11, wherein the surface resistance of the deposited conductive layer coated onto the substrate is preferably less than 200 Ω/□.

13. The layered body according to claim 11 or 12, wherein the transmission of the layered body in those areas in which the substrate is coated with the conductive layer is at least 80 %.

14. Use of the composition according to one of claims 1 to 9 for the production of an electrically conductive layer in an OLED, an OPV element, a touch screen, for shielding from electromagnetic radiation ("EMI shielding"), in sensors or for the production of an IR reflection layer, wherein the electrically conductive layer is prepared by means of inkjet printing.

15. Use of the composition according to claim 14 for the deposition of bezel electrodes in touch panel devices.
